# EUROPEAN PATENT APPLICATION

(11) **EP 2 385 564 A2**
(43) Date of publication of application: **09.11.2011**
(21) Application number: 11164584.2
(22) Date of filing: 03.05.2011
(51) Int. Cl.: H01L 51/44, H01L 27/30

(54) **Method of manufacturing an organic photovoltaic device**

(30) Priority: 06.05.2010 IN DE10632010
(71) Applicant: Moser Baer India Limited, New Delhi 110020 (IN)
(72) Inventor: Agrawal, Nikhil, 110020, New Dehli (IN); Rajeswaran, Gopalan, 110020, New Dehli (IN); Jindal, Rajeev, 110020, New Dehli (IN)
(74) Representative: Beck, Michael Rudolf

(57) **Abstract**

A method of manufacturing an organic photovoltaic device (600a, 600b) of a pre-defined surface area substantially equal to and not greater than 900 square centimeters without involving a cutting process is provided. The method includes providing a first substrate (502) with a size substantially equal to said pre-defined surface area and depositing an organic photoactive layer (504) on the first substrate (502) followed by depositing an electrically conducting layer (506) on the organic photoactive layer (504) using a high-throughput process. Thereafter, the electrically conducting layer (506) and the organic photoactive layer (504) are scribed from the first substrate (502) using a high-throughput process, whereby forming an active substrate (500a). Further, providing a second substrate (602) with a size substantially equal to the pre-defined surface area and depositing a gas-absorbent layer (604) on the second substrate (602) using a high-throughput process whereby forming an inactive substrate (605). Finally, encapsulating the active substrate (500a) with the inactive substrate (605) to form the organic photovoltaic device (600a, 600b) with the pre-defined surface area.

## Description

The invention disclosed herein relates, in general, to a method of manufacturing organic photovoltaic devices. More specifically, the present invention relates to a method of manufacturing an organic photovoltaic device using high-throughput processes.

A photovoltaic device converts incident light into electrical energy. The photovoltaic device has one or more photoactive layers deposited on a substrate. These photoactive layers are capable of generating excitons, i.e., bound electron-hole pairs, on receiving solar energy in the form of light. These electron-hole pairs dissociate into charge carrying electrons and holes, thereby generating electricity. The generated electrons are drawn as current in an external circuit connected to the photovoltaic device.

Organic photovoltaic devices, i.e., photovoltaic devices having photoactive layer made of organic materials to generate electricity, have become attractive because of their low cost as compared to inorganic photovoltaic device, e.g., a silicon-doped solar cell. Examples of organic material include, but are not limited to polyphenylene vinylene, copper phthalocyanine, carbon fullerenes or fullerene derivatives. However, these organic photovoltaic devices have disadvantage of having low efficiency and low current density.

To overcome the above drawbacks, organic photovoltaic devices are manufactured in large sizes employing large substrate, i.e., manufacturing large substrate area products. Manufacturing photovoltaic devices with the large substrate area appears theoretically cost-effective as more area can be processed in one go. However, manufacturing the large substrate area photovoltaic devices has its own disadvantages. For example, use of the large substrate area photovoltaic devices in smaller applications like mobile chargers, solar lantern, calculators, MP3 players etc., requires the large substrate area product to be cut in smaller parts. This additional step of cutting induces area losses and requires additional time thereby reducing yield.

Further, in manufacture of the large substrate area photovoltaic devices uniformity of layers deposited over the substrate is not maintained. Also, there are defects such as pinholes, inhomogeneity etc. in the deposited layers. Additionally, customized equipments are required for processing the large substrates which in turn increase the capital cost. Therefore, the large substrate area photovoltaic devices or smaller photovoltaic devices manufactured by cutting the large substrate area product are poor in quality, inefficient and costly.

According to the foregoing discussion, it can be observed that there is scope for improvement in the methods for manufacturing photovoltaic devices owing to their one or more limitations. There is therefore a need for a manufacturing method that can mass manufacture high quality photovoltaic devices with high yield using substrates with small area and overcome some or all of the limitations identified above.

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIG. 1 is a flow chart describing a method of manufacturing an organic photovoltaic device, in accordance with a first embodiment of the present invention;
FIG. 2 is a flow chart describing a method of manufacturing the organic photovoltaic device, in accordance with a second embodiment of the present invention;
FIG. 3 is a flow chart describing a method of manufacturing the organic photovoltaic device, in accordance with a third embodiment of the present invention;
FIG. 4 is a flow chart describing a method for encapsulating an active substrate with an inactive substrate, in accordance with an exemplary embodiment of the present invention;
FIGs. 5a and 5b are diagrammatic illustrations of a first substrate deposited with one or more layers, in accordance with at least the first, the second and the third embodiments of the present invention;
FIGs. 6a and 6b are diagrammatic illustrations of the first substrate and a second substrate deposited with corresponding one or more layers, in accordance with at least the first, the second and the third embodiments of the present invention;
FIG. 7 is a diagrammatic illustrations of the active substrate, in accordance with an embodiment of the present invention;
FIGs. 8a, 8b and 8c are diagrammatic illustrations of the active substrate at different steps of a method of manufacturing the organic photovoltaic device, in accordance with at least the third embodiment of the present invention; and
FIG. 9 is a diagrammatic illustration of a real-life application of one or more organic photovoltaic devices connected with series or parallel connections, in accordance with another exemplary embodiment of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

The instant exemplary embodiments provide a method of manufacturing an organic photovoltaic device.

Some embodiments provide a method of manufacturing the organic photovoltaic device, which can be used for mass manufacturing.

Some embodiments provide a cost-effective method of manufacturing the organic photovoltaic device, which can be used for mass manufacturing.

Some embodiments provide a method of manufacturing the organic photovoltaic device, such that a capital investment for a manufacturing facility to implement the method is less.

Some embodiments provide a method of manufacturing the organic photovoltaic device that eliminates or reduces the limitations involved in manufacturing the organic photovoltaic device using a large substrate.

In some embodiments, a method is provided for manufacturing an organic photovoltaic device of a pre-defined surface area. The method includes providing a first substrate of substantially the pre-defined surface area, and depositing an organic photoactive layer on the first substrate. Thereafter, the method includes depositing an electrically conducting layer on the organic photoactive layer. Additionally, a second substrate of substantially the pre-defined surface area is provided and a gas-absorbent layer is deposited on the second substrate. The first substrate is then encapsulated with the second substrate to form the organic photovoltaic device of the pre-defined surface area. The method is characterized such that the pre-defined surface area is equal to and not greater than 900 square centimeters. Also, the organic photoactive layer is deposited by using either a batch deposition-process or an in-line process and the electrically conducting layer is deposited by using a first high-throughput deposition-processing, wherein the first high-throughput deposition-processing is substantially suitable for said pre-defined surface area. Further, the gas-absorbent layer is deposited by using a second high-throughput deposition-processing, wherein the second high-throughput deposition-processing is substantially suitable for said pre-defined surface area.

Therefore, the method of manufacturing the organic photovoltaic device did not require the cutting process to achieve the pre-defined surface area.

In some embodiments, a method is provided for manufacturing an organic photovoltaic device of a pre-defined surface area. The method includes providing a first substrate of substantially the pre-defined surface area, and depositing an organic photoactive layer on the first substrate. Thereafter, the method includes depositing an electrically conducting layer on the organic photoactive layer. Then, the method includes scribing of the electrically conducting layer and the organic photoactive layer from the first substrate. Then, the method includes scribing of the electrically conducting layer and the organic photoactive layer from the first substrate. Additionally, a second substrate of substantially the pre-defined surface area is provided and a gas-absorbent layer is deposited on the second substrate. The first substrate is then encapsulated with the second substrate to form the organic photovoltaic device of the pre-defined surface area. The method is characterized such that the pre-defined surface area is equal to and not greater than 900 square centimeters. Also, the organic photoactive layer is deposited by using either a batch deposition-process or an in-line process and the electrically conducting layer is deposited by using a first high-throughput deposition-processing, wherein the first high-throughput deposition-processing is substantially suitable for said pre-defined surface area. The electrically conducting layer and the organic photoactive layer are scribed from the first substrate using a high-throughput process. Further, the gas-absorbent layer is deposited by using a second high-throughput deposition-processing, wherein the second high-throughput deposition-processing is substantially suitable for said pre-defined surface area. The organic photovoltaic device manufactured did not require the cutting process to achieve the pre-defined surface area.

In some embodiments, the method of manufacturing the organic photovoltaic device comprises depositing a high-throughput depositing of a hole-transport layer on the first substrate, such that the high-throughput depositing of the hole-transport layer is suitable for the pre-defined surface area. Thereafter, a first organic photoactive layer is deposited on the hole-transport layer by using either a batch deposition-process or an in-line process.

Optionally, the method may include high-throughput depositing of a first electrically conducting layer on the first organic photoactive layer, such that the optional high-throughput depositing of the first electrically conducting layer is suitable for the pre-defined surface area. Further, the method may also include optionally depositing a second organic photoactive layer on the first electrically conducting layer such that the second organic photoactive layer is deposited by using a batch deposition-process or an in-line process.

Then, the method includes high-throughput scribing of the second organic photoactive layer, the first electrically conducting layer, the first organic photoactive layer and the hole-transport layer from the first substrate, followed by high-throughput depositing of a second electrically conducting layer, such that, the high-throughput depositing is suitable for the pre-defined surface area. Thereafter, the second electrically conducting layer is scribed using high-throughput scribing, thereby forming an active substrate.

Additionally, a second substrate of a surface area substantially equal to and not greater than the pre-defined surface area is provided, and a high-throughput depositing of a gas-absorbent layer is performed on it to form an inactive substrate. The high-throughput depositing of the gas-absorbent layer is also suitable for the pre-defined surface area.

Thereafter, the active substrate is encapsulated or bonded with the inactive substrate to form the organic photovoltaic device. The organic photovoltaic device is capable of generating electricity without a subsequent cutting process.

In some embodiments, each layer from the hole-transport layer, the first organic photoactive layer, the first electrically conducting layer, the second organic photoactive layer, the second electrically conducting layer and the gas-absorbent layer is deposited by using a high-throughput manufacturing process that is suitable for the pre-defined surface area, i.e., a small form factor. Some examples of the high-throughput manufacturing process include, but are not limited to, dip coating, spin coating, doctored blade processing, spray coating, screen printing, sputtering, electroforming, evaporation and an in-line process.

Before describing the present invention in detail, it should be observed that the present invention utilizes a combination of method steps and apparatus components related to a method of manufacturing an organic solar cell. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

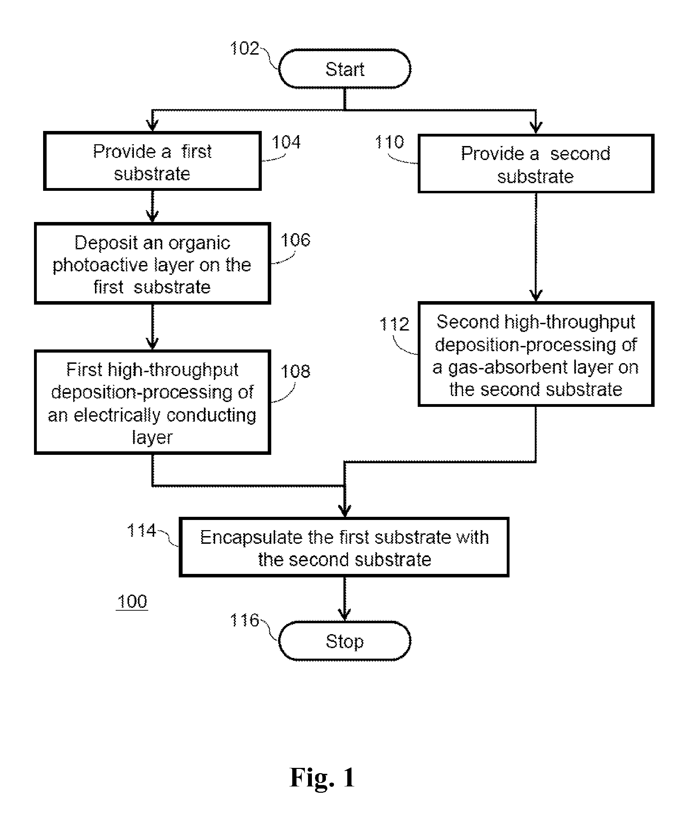

Referring now to the drawings, FIG. 1 is a flow chart describing a method 100 of manufacturing an organic photovoltaic device, in accordance with a first embodiment of the present invention. The organic photovoltaic device has a pre-defined surface area.

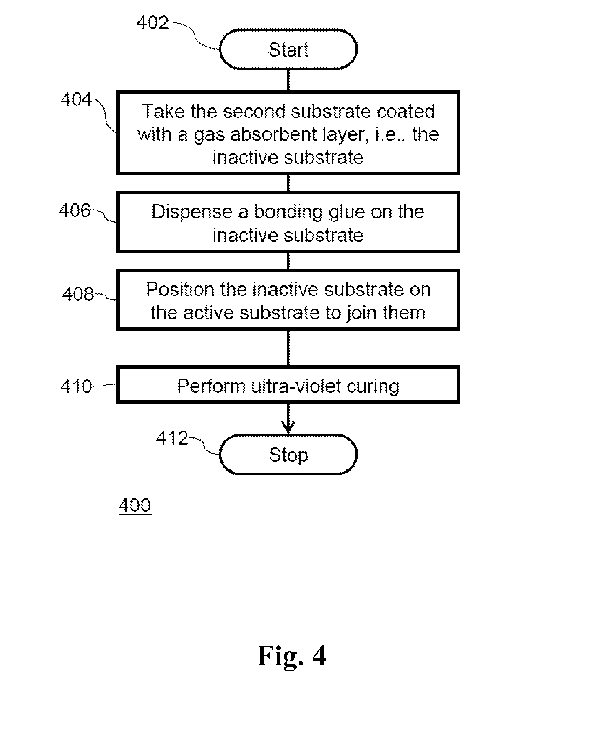

In the subsequent description of the method 100, reference will be made to FIGs. 4, 5a, 5b, 6a, 6b and 7 to elaborate on structural information pertaining to various embodiments of the organic photovoltaic device and the method 100.

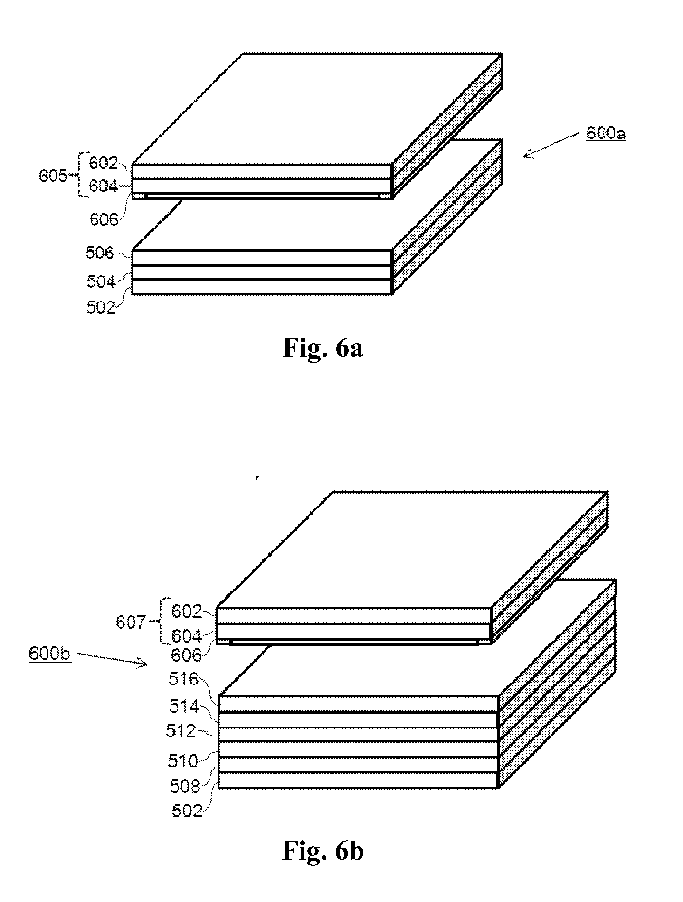

For the purpose of this description, the method 100 is explained for manufacturing of an organic photovoltaic device 600a (Refer FIG. 6a). However, it will be readily apparent to those ordinarily skilled in the art that the method 100 can be used for manufacturing of an organic photovoltaic device 600b (Refer FIG. 6b) or another organic photovoltaic device having the layers of the organic photovoltaic device 600a along with one or more additional layers.

The method 100 is initiated at step 102. At step 104, a first substrate 502 is provided. A size of the first substrate 502 is substantially equal to a pre-defined surface area, which is not greater than 900 square centimetres. For example, the first substrate 502 can be a square substrate of dimensions not greater than 30 cm X 30 cm. The square substrate of dimensions substantially equal to and not greater than 30 cm X 30 cm, is a standard-sized substrate, and significant number of manufacturing processes and equipments are standardized and optimized for a substrate of this size or surface area. For example, processes like, dip coating, spin coating, doctored blade processing, spray coating, screen printing, sputtering, electroforming and evaporation are already standardized for such a size and the corresponding manufacturing equipments are available as standard equipments.

In accordance with this invention, the first substrate 502 can be of any shape as long as the size of the first substrate 502 is substantially equal to but not greater than 900 square centimeters. For example, in one embodiment the first substrate 502 can be circular in shape, however, in another embodiment, the shape of the first substrate 502 can be, but is not limited to, polygonal, annular or elliptical.

In one embodiment, the first substrate 502 may include a glass substrate coated with an electrically conducting layer or an electrically conducting grid. Examples of the electrically conducting layer include, but are not limited to, a transparent conducting oxide (TCO), like, Indium Tin Oxide (ITO), Fluorine doped Tin Oxide (FTO), and Aluminum doped Zinc Oxide or a Carbon Nanotube Layer. Examples of the electrically conducting grid may include, but are not limited to, grids made from Aluminum, Copper, Gold, Silver, Polysilicon and a Silicide. In other embodiment, the first substrate 502 may include a transparent plastic substrate coated with an electrically conducting layer or an electrically conducting grid.

In an embodiment, the first substrate 502 is cleaned prior to performing subsequent steps of the method 100. For example, the first substrate 502 may be cleaned using an Ultrasonic or a Megasonic cleaning technique.

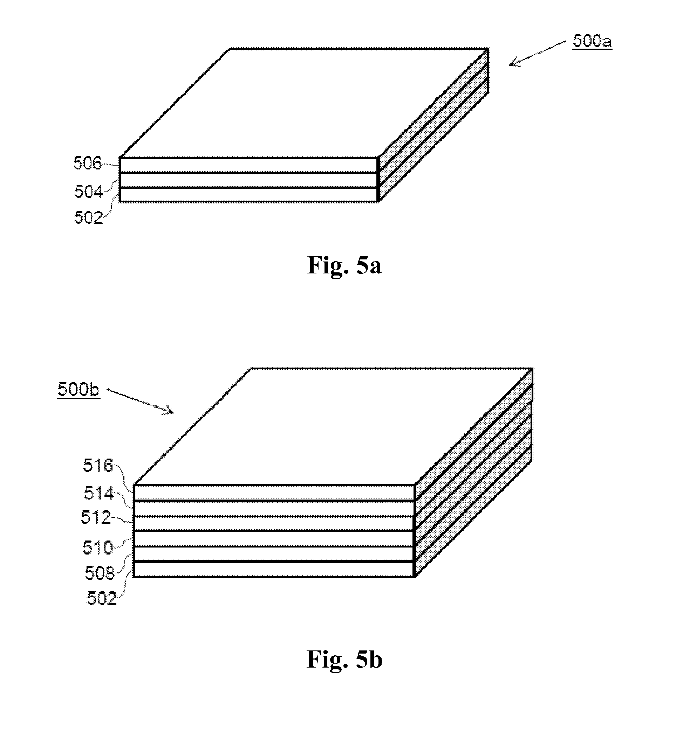

Thereafter, at step 106 an organic photoactive layer 504 (Refer FIG. 5a) is deposited on the first substrate 502. The organic photoactive layer 504 is responsible for generation of electricity in the organic photovoltaic device 600a. Photons present in the sun light received by the organic photoactive layer 504 generate excitons, i.e., bound electron-hole pairs, within the organic photoactive layer 504. These bound electron-hole pairs dissociate into free electrons and holes within the organic photoactive layer 504. The free electrons and holes act as the charge carriers that are responsible for generating electricity.

Examples of materials used for the organic photoactive layer 504, include, but are not limited to, polyphenylene vinylene, copper phthalocyanine, carbon fullerenes and fullerene derivatives such as Phenyl-C61-butyric acid methyl ester, i.e., PCBM.

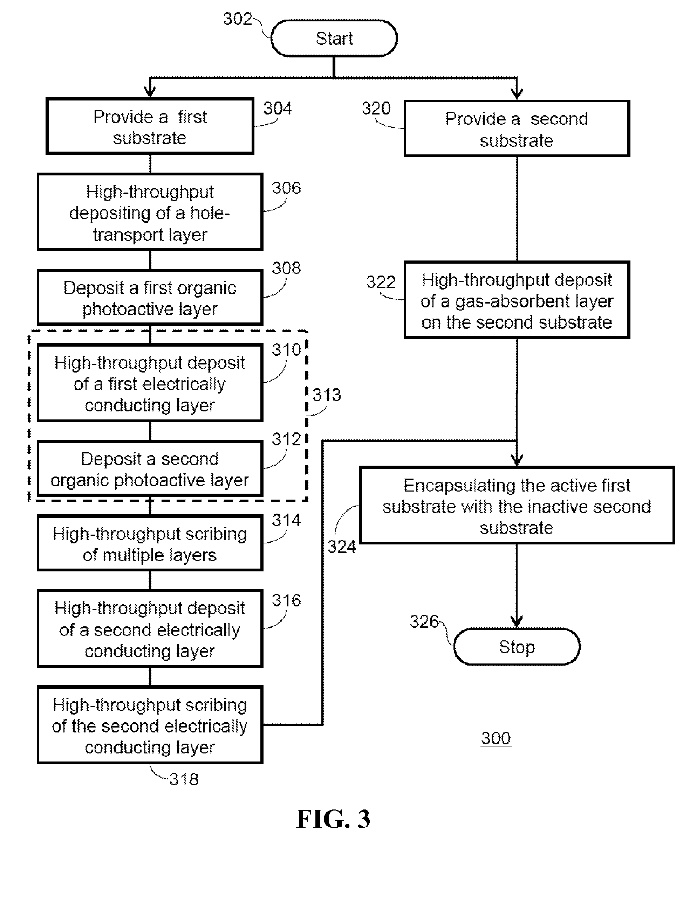

In another embodiment, the organic photovoltaic device 600a may also include a hole-transport layer. The hole-transport layer is deposited on the first substrate 502 prior to depositing the organic photoactive layer. The hole-transport layer is provided to enhance the transport of holes in the organic photovoltaic device 600a, thereby enhancing the efficiency of the organic photovoltaic device 600a. This embodiment is illustrated in conjunction with FIG. 3.

The organic photoactive layer 504 is deposited by using a batch deposition-process or an in-line process.

In the batch process for depositing the organic photoactive layer 504, for example, an input set of multiple first substrates is provided. The organic photoactive layer 504 is deposited on each first substrate 502 of the multiple first substrates. An output of the batch process is a set of multiple deposited first substrates, i.e., a set of the multiple first substrates deposited with the organic photoactive layer 504. Thereafter, the multiple deposited first substrates are carried forward for further processing as per subsequent steps of the method 100.

In an in-line process, for example, the first substrate 502 is received as an input, deposited with the organic photoactive layer 504, and a deposited first substrate is provided as an output. Thereafter, the deposited first substrate is carried forward for further processing as per the subsequent steps of the method 100, while another first substrate is received as an input.

Examples of processes that can be implemented as the batch-deposition process and the in-line process for the step 106 include, but are not limited to, dip coating, spin coating, doctored blade processing, spray coating, screen printing, sputtering, electroforming and evaporation.

It will be readily apparent to those ordinarily skilled in the art that either of the batch process and the in-line process may be included in the method 100 without deviating from the scope of the invention. It will also be readily apparent to those ordinarily skilled in the art that the method 100 may be optimized for high-throughput by using either the batch process or the in-line process.

At step 108, an electrically conducting layer 506 is deposited on the organic photoactive layer 504 using a first high-throughput deposition-processing.

The first high-throughput deposition-processing is performed using a manufacturing process which is suitable for the pre-defined surface area, i.e., the small form factor of substrates. Examples of the manufacturing process include, but are not limited to, dip coating, spin coating, doctored blade processing, spray coating, screen printing, sputtering, electroforming and evaporation.

Most of the high-throughput manufacturing process mentioned above have been optimized and standardized for the pre-defined surface area, i.e., for a surface area of substantially equal to but not greater than 900 square centimeters. However, there are limitations on using these processes for larger substrates, i.e., for substrates larger than the pre-defined surface area. They tend to generate outputs of sub-optimal quality or efficiency. For example, the uniformity of thickness of layers deposited by using spin coating may not be maintained over the large substrates. It may also induce defects, like, pinholes and non-homogeneity of the layers when used on large substrates.

Generally, a high-throughput manufacturing process is a process that is suitable for mass production, and therefore, produces a large quantity of products in a given time. In context of the method 100, when a method step is mentioned to have a high-throughput, for example, the step 108 of the high-throughput deposition of the electrically conducting layer 506, it refers that the method step is suitable to be performed for producing a bulk quantity of organic photovoltaic devices. Generally, the high-throughput process can be defined as a process capable of processing nearly 2.5 million products per year. In other words, the high-throughput process is a process that requires nearly 10 seconds for processing each product. Therefore, the high-throughput deposition of the electrically conducting layer 506 on the organic material layer 504 of the first substrate 502 is substantially performed in nearly 10 seconds.

Although, the high-throughput process is explained in reference to the first high-throughput deposition-processing of the electrically conducting layer 506 on the first substrate 502, it will be readily apparent to those ordinarily skilled in the art that another method step in the method 100 that is mentioned to be a high-throughput process may be substantially similar to the high-throughput process in context of producing nearly 2.5 million products per year and requiring nearly 10 seconds for processing each product.

It will also be appreciated by a person skilled in the art that a production capacity of 2.5 million products per year and a tact time of 10 seconds are provided only as an example for illustrating the high-throughput process, and do not depict any limitation of the invention. The production capacity and the tact time of the high-throughput process, in accordance with the present invention, may be higher or lower than the ranges mentioned above.

The electrically conducting layer 506 deposited on the organic photovoltaic layer 504 acts as one of the electrical contacts for connecting the organic photovoltaic device 600a to an external circuit requiring electricity or one or more organic photovoltaic devices. Generally, the electrically conducting layer 506 deposited on the organic photovoltaic layer 504 acts as a cathode. The electrically conducting layer or the electrically conducting grid deposited on the glass substrate, of the first substrate 502, acts as another electrical contact for connecting the organic photovoltaic device 600a to the external circuit requiring electricity or to the one or more organic photovoltaic devices. Generally, the electrically conducting layer or the electrically conducting grid deposited on the glass substrate, of the first substrate 502, acts as an anode.

Examples of the electrically conducting layer 506 include, but are not limited to, a transparent conducting oxide (TCO), like, Indium Tin Oxide (ITO), Fluorine doped Tin Oxide (FTO), and Aluminum doped Zinc Oxide or a Carbon Nanotube Layer.

At step 110, a second substrate 602 (Refer FIG. 6a) is provided having a size substantially equal to and not greater than the pre-defined surface area of less than 900 square centimeters, i.e., the small form factor. Examples of the material of the second substrate 602 include, but are not limited to, glass.

In an embodiment, the second substrate 602 is cleaned prior to performing subsequent steps of the method 100. For example, the second substrate 602 may be cleaned using an Ultrasonic or a Megasonic cleaning technique.

At step 112, a gas-absorbent layer 604 is deposited on the second substrate 602 using a second high-throughput deposition-processing, thereby forming an inactive substrate 605. The second high-throughput deposition-processing of the gas-absorbent layer 604 is performed using a manufacturing process which is suitable for the pre-defined surface area, i.e., the small form factor of substrates. Examples of the manufacturing process include, but are not limited to, dip coating, spin coating, doctored blade processing, spray coating, screen printing, sputtering, electroforming and evaporation.

The gas-absorbent layer 604 is provided to absorb any gases that are released during the method 100 of manufacturing the organic photovoltaic device 600a and during a use of the organic photovoltaic device 600a. For example, the organic photovoltaic device 600a may undergo a curing process or exposure to heat and/or strong ultra-violet rays during the manufacturing in accordance with the method 100. This may result in release of contaminating gases from one or more layers in the organic photovoltaic device 600a. The gas-absorbent layer 604 prevents contamination of the organic photovoltaic device 600a from the contaminating gases.

At step 114, the first substrate 502, which is deposited with one or more layers 504 and 506 as per the foregoing steps of the method 100, is encapsulated or bonded with the second substrate 602, which is deposited with the gas-absorbent layer 604. In the subsequent description of the method 100, the first substrate 502, which is deposited with the one or more layers 504 and 506, is referred to as an active substrate 500a. Similarly, the second substrate 602, which is deposited with the gas-absorbent layer 604, is referred to as an inactive substrate 605.

The active substrate 500a is so termed as it includes the organic photoactive layer 504 capable of generating electricity. Similarly, the inactive substrate 605 is so termed as it does not include a layer capable of generating electricity.

A process of encapsulation is explained with reference to a method 400 depicted by a flow chart in FIG. 4. The method 400 initiates at step 402, the inactive substrate 605 is taken at step 404 and a bonding glue 606 is dispensed on the inactive substrate 605 at step 406. The bonding glue 606 is dispensed on a surface of the inactive substrate 605 that has the gas-absorbent layer 604. Thereafter, at step 408, the inactive substrate 605, dispensed with bonding glue 606 is positioned over the active substrate 500a. The gas-absorbent layer 604 may absorb any gases trapped between the active substrate 500a and the inactive substrate 605 during the step 406. Thereafter, at step 410, an exposure of ultra-violet radiation is provided to perform ultra-violet curing and complete the encapsulation of the active substrate 500a with the inactive substrate 605. The gas-absorbent layer 604 may absorb any gases released during the step 408. The encapsulation method terminates at step 412. Although, the method 400 is shown to include ultra-violet curing, it will be readily apparent to those ordinarily skilled in the art that other forms of curing may also be performed without deviating from the scope of the invention.

Thereafter, the method 100 of manufacturing the organic photovoltaic device 600a also terminates at step 116.

As per the foregoing description of steps involved in the method 100, the method 100 does not involve a cutting process. Absence of the cutting process makes the method 100 efficient. Additionally, since the cutting process is not involved, a size of the organic photovoltaic device 600a is substantially similar to a size of the first substrate 502 and/or the second substrate 602, i.e., an input substrate is similar in size to an output device.

Each of the steps involved in the method 100 may be performed by either a batch process or an inline process. Further, the each of the steps involved in the method 100 may be implemented in such a way that a tact time of the manufacturing facility used to implement the method 100 is optimum. In an exemplary scenario, a time corresponding to each of the method steps in method 100 is designed to be substantially same, thereby reducing a waiting time between each process and optimizing the tact time for the manufacturing facility.

In real life applications, one or more organic photovoltaic devices manufactured as per the method 100 may be connected by using series or parallel connections to obtain an arrangement that can produce electrical output as per a requirement. Additionally, the one or more organic photovoltaic devices may be connected by using series or parallel connections to obtain an optimum electrical output.

In an exemplary real life scenario, an electrical equipment with a voltage requirement of 42 volts needs to be run using solar energy. Further, in this exemplary scenario, the voltage output of the organic photovoltaic device can be 4.2 volts (0.7 volts per strip X 6 strips, 702a, 702b, 702c, 702d, 702e and 702f). Therefore, 10 such organic photovoltaic devices can be connected in series to obtain the required output of 42 volts and run the electrical equipment with solar energy.

It will be readily apparent to those ordinarily skilled in the art that the one or more organic photovoltaic devices may also be connected with photovoltaic devices prepared from other methods in real life applications.

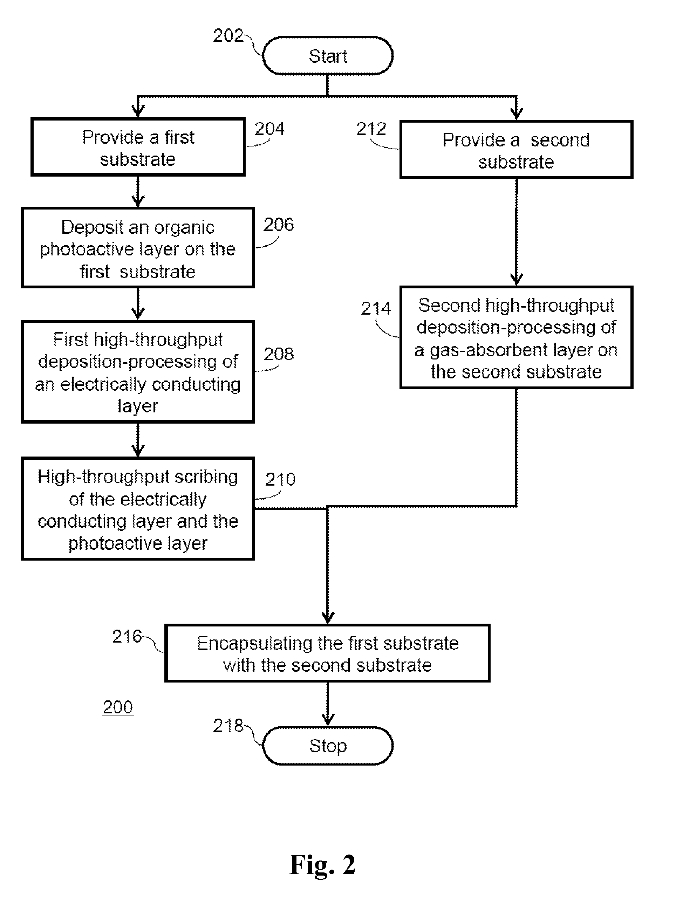

Referring now to the drawings, FIG. 2 is a flow chart describing a method 200 of manufacturing an organic photovoltaic device, in accordance with the second embodiment of the present invention. The organic photovoltaic device has a pre-defined surface area.

In the subsequent description of the method 200, reference will be made to FIGs. 4, 5a, 5b, 6a and 6b to elaborate on structural information pertaining to various embodiments of the organic photovoltaic device and the method 200.

For the purpose of this description, the method 200 is explained for manufacturing of an organic photovoltaic device 600a (Refer FIG. 6a). However, it will be readily apparent to those ordinarily skilled in the art that the method 200 can be used for manufacturing of an organic photovoltaic device 600b (Refer FIG. 6b) or another organic photovoltaic device having the layers of the organic photovoltaic device 600a along with one or more additional layers.

The method 200 is initiated at step 202. At step 204, a first substrate 502 is provided. A surface area of the first substrate 502 is substantially equal to the pre-defined surface area, which is not greater than 900 square centimeters. For example, the first substrate 502 can be a square substrate of dimensions not greater than 30 cm X 30 cm. The square substrate of dimensions substantially equal to and not greater than 30 cm X 30 cm, is a standard-sized substrate, and significant number of manufacturing processes and equipments are standardized and optimized for a substrate of this size or surface area. For example, processes like, dip coating, spin coating, doctored blade processing, spray coating, screen printing, sputtering, electroforming and evaporation are already standardized for such a size and the corresponding manufacturing equipments are available as standard equipments.

In accordance with this invention, the first substrate 502 can be of any shape as long as the surface area of the first substrate 502 is substantially equal to but not greater than 900 square centimeters. For example, in one embodiment the first substrate 502 can be circular in shape, however, in another embodiment, the shape of the first substrate 502 can be, but is not limited to, polygonal, annular or elliptical.

In one embodiment, the first substrate 502 may include a glass substrate coated with an electrically conducting layer or an electrically conducting grid. Examples of the electrically conducting layer include, but are not limited to, a transparent conducting oxide (TCO), like, Indium Tin Oxide (ITO), Fluorine doped Tin Oxide (FTO), and Aluminum doped Zinc Oxide or a Carbon Nanotube Layer. Examples of the electrically conducting grid may include, but are not limited to, grids made from Aluminum, Copper, Gold, Silver, Polysilicon and a Silicide. In other embodiment, the first substrate 502 may include a transparent plastic substrate coated with an electrically conducting layer or an electrically conducting grid.

In an embodiment, the first substrate 502 is cleaned prior to performing subsequent steps of the method 200. For example, the first substrate 502 may be cleaned using an Ultrasonic or a Megasonic cleaning technique.

Thereafter, at step 206 organic photoactive layer 504 (Refer FIG. 5a) is deposited on the first substrate 502. The organic photoactive layer 504 is responsible for generation of electricity in the organic photovoltaic device 600a. Photons present in the sun light received by the organic photoactive layer 504 generate excitons, i.e., bound electron-hole pairs, within the organic photoactive layer 504. These bound electron-hole pairs dissociate into free electrons and holes within the organic photoactive layer 504. The free electrons and holes act as the charge carriers that are responsible for generating electricity.

Examples of materials used for the organic photoactive layer 504, include, but are not limited to, polyphenylene vinylene, copper phthalocyanine, carbon fullerenes and fullerene derivatives such as Phenyl-C61-butyric acid methyl ester, i.e., PCBM.

In another embodiment, one or more organic material layers may be deposited on the first substrate 502 instead of the organic photoactive layer 504. The one or more organic material layers may include the organic photoactive layer 504 and a hole-transport layer. The hole-transport layer is deposited prior to depositing an organic photoactive layer 504. The hole-transport layer is provided to enhance the transport of holes in the organic photovoltaic device 600a, thereby enhancing the efficiency of the organic photovoltaic device 600a.

Each of said one or more organic material layers, i.e., the hole-transport layer and the organic photoactive layer 504 is deposited by using a batch deposition-process or an in-line process.

In the batch process for depositing the organic photoactive layer 504, for example, an input set of multiple first substrates is provided. The organic photoactive layer 504 is deposited on each first substrate 502 of the multiple first substrates. An output of the batch process is a set of multiple deposited first substrates, i.e., a set of the multiple first substrates deposited with the organic photoactive layer 504. Thereafter, the multiple deposited first substrates are carried forward for further processing as per subsequent steps of the method 200.

In an in-line process, for example, the first substrate 502 is received as an input, deposited with the organic photoactive layer 504, and a deposited first substrate is provided as an output. Thereafter, the deposited first substrate is carried forward for further processing as per the subsequent steps of the method 200, while another first substrate is received as an input.

Examples of processes that can be implemented as the batch-deposition process and the in-line process for the step 206 include, but are not limited to, dip coating, spin coating, doctored blade processing, spray coating, screen printing, sputtering, electroforming and evaporation.

It will be readily apparent to those ordinarily skilled in the art that either of the batch process and the in-line process may be included in the method 200 without deviating from the scope of the invention. It will also be readily apparent to those ordinarily skilled in the art that the method 200 may be optimized for high-throughput by using either the batch process or the in-line process.

At step 208, a first high-throughput deposition-processing is performed on the organic photoactive layer 504 to deposit an electrically conductive layer 506. Irrespective of a presence of the hole-transport layer, the first high-throughput deposition-processing is performed on the organic photoactive layer 504.

The first high-throughput deposition-processing is performed using a manufacturing process which is suitable for the pre-defined surface area, i.e., the small form factor of substrates. Examples of the manufacturing process include, but are not limited to, dip coating, spin coating, doctored blade processing, spray coating, screen printing, sputtering, electroforming and evaporation.

Most of the high-throughput manufacturing process mentioned above have been optimized and standardized for the pre-defined surface area, i.e., for a surface area of substantially equal to but not greater than 900 square centimeters. However, there are limitations on using these processes for larger substrates, i.e., for substrates larger than the pre-defined surface area. They tend to generate outputs of sub-optimal quality or efficiency. For example, the uniformity of thickness of layers deposited by using spin coating may not be maintained over the large substrates. It may also induce defects, like, pinholes and non-homogeneity of the layers when used on large substrates.

Generally, a high-throughput manufacturing process is a process that is suitable for mass production, and therefore, produces a large quantity of products in a given time similar to the high-throughput manufacturing process explained in conjunction with the method 100.

In an embodiment the electrically conducting layer 506 is deposited on the organic photoactive layer 504. Similarly, in the embodiment when both the hole-transport layer and the organic photoactive layer 504 are present, the electrically conducting layer 506 is deposited on the organic photoactive layer 504.

The electrically conducting layer 506 deposited on the organic photovoltaic layer 504 acts as one of the electrical contacts for connecting the organic photovoltaic device 600a to an external circuit requiring electricity or one or more organic photovoltaic devices. Generally, the electrically conducting layer 506 deposited on the organic photovoltaic layer 504 acts as a cathode. The electrically conducting layer or the electrically conducting grid deposited on the glass substrate, of the first substrate 502, acts as another electrical contact for connecting the organic photovoltaic device 600a to the external circuit requiring electricity or to the one or more organic photovoltaic devices. Generally, the electrically conducting layer 506 or the electrically conducting grid 506 deposited on the glass substrate, of the first substrate 502, acts as an anode.

Examples of the electrically conducting layer 506 include, but are not limited to, a transparent conducting oxide (TCO), like, Indium Tin Oxide (ITO), Fluorine doped Tin Oxide (FTO), and Aluminum doped Zinc Oxide or a Carbon Nanotube Layer.

Thereafter, at step 210, the organic photoactive layer 504 and the electrically conducting layer 506 are scribed from the first substrate 502 using a high-throughput method.

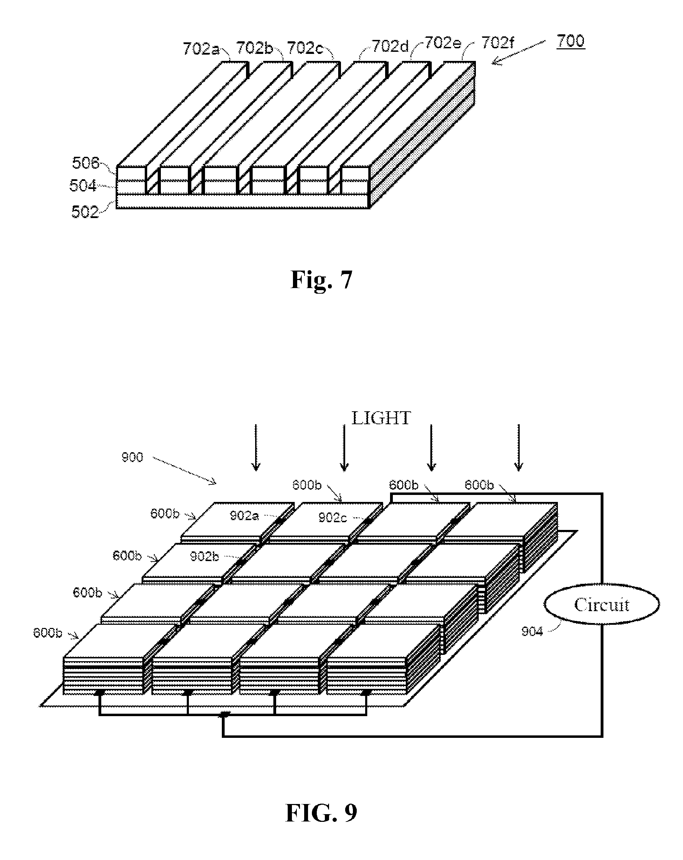

Referring to FIG. 7, the high-throughput scribing of the organic photoactive layer 504, the electrically conducting layer 506 forms strips 702a, 702b, 702c, 702d, 702e and 702f on the first substrate 502 and also connects the strips 702a, 702b, 702c, 702d, 702e and 702f in series to form an active substrate 700.

A strip voltage across the electrically conducting layer or the electrically conducting grid of the first substrate 502 and the electrically conducting layer 506 is substantially similar for the each strip. For example, in a hypothetical scenario, the strip voltage can be 0.7 volts. When the strips 702a, 702b, 702c, 702d, 702e and 702f are connected in series at the step 110 to form the active substrate 700, a combined voltage of the active substrate 700 is substantially equivalent to an addition of the strip voltages of all the strips 702a, 702b, 702c, 702d, 702e and 702f, i.e., 0.7 X6 = 4.2 volts.

At step 212, a second substrate 602 (Refer FIG. 6a) is provided having a surface area substantially equal to and not greater than the pre-defined surface area of less than 900 square centimeters, i.e., the small form factor. Examples of the material of the second substrate 602 include, but are not limited to, glass.

In an embodiment, the second substrate 602 is cleaned prior to performing subsequent steps of the method 200. For example, the second substrate 602 may be cleaned using an Ultrasonic or a Megasonic cleaning technique.

At step 212, a second high-throughput deposition-processing is performed on the second substrate 602 to deposit a gas-absorbent layer 604. The second high-throughput deposition-processing is performed using a manufacturing process which is suitable for the pre-defined surface area, i.e., the small form factor of substrates. Examples of the manufacturing process include, but are not limited to, dip coating, spin coating, doctored blade processing, spray coating, screen printing, sputtering, electroforming and evaporation.

The gas-absorbent layer 604 is provided to absorb any gases that are released during the method 200 of manufacturing the organic photovoltaic device 600a and during a use of the organic photovoltaic device 600a. For example, the organic photovoltaic device 600a may undergo a curing process or exposure to heat and/or strong ultra-violet rays during the manufacturing in accordance with the method 200 (Refer description of step 214). This may result in a release of contaminating gases from one or more layers in the organic photovoltaic device 600a. The gas-absorbent layer 604 prevents contamination of the organic photovoltaic device 600a from the contaminating gases.

At step 216, the first substrate 502, which is deposited with one or more layers 504 and 506 as per the foregoing steps of the method 200, is encapsulated or bonded with the second substrate 602, which is deposited with the gas-absorbent layer 604. In the subsequent description of the method 200, the first substrate 502, which is deposited with the one or more layers 504 and 506, is referred to as an active substrate 500a. Similarly, the second substrate 602, which is deposited with the gas-absorbent layer 604, is referred to as an inactive substrate 605.

The active substrate 500a is so termed as it includes the organic photoactive layer 504 capable of generating electricity. Similarly, the inactive substrate 605 is so termed as it does not include a layer capable of generating electricity.

The method of encapsulation is similar to the method 400 explained with reference to FIG. 4 in conjunction with the foregoing description of method 100. Thereafter, the method 200 of manufacturing the organic photovoltaic device 600a also terminates at step 218.

As per the foregoing description of steps involved in the method 200, the method 200 does not involve a cutting process. Absence of the cutting process makes the method 200 efficient. Additionally, since the cutting process is not involved, a size of the organic photovoltaic device 600a is substantially similar to a size of the first substrate 502 and/or the second substrate 602, i.e., an input substrate is similar in size to an output device.

Each of the steps involved in the method 200 may be performed by either a batch process or an inline process. Further, the each of the steps involved in the method 200 may be implemented in such a way that a tact time of the manufacturing facility used to implement the method 200 is optimum. In an exemplary scenario, a time corresponding to each of the method steps in method 200 is designed to be substantially same, thereby reducing a waiting time between each process and optimizing the tact time for the manufacturing facility.

Referring now to FIG. 3, there is shown a flow chart describing a method 300 of manufacturing an organic photovoltaic device 600b (Refer FIG. 6), in accordance with the third embodiment of the present invention. The organic photovoltaic device 600b has the pre-defined surface area, which is not greater than 900 square centimeters.

In the subsequent description of the method 300, reference will be made to FIGs. 4, 5a, 5b, 6a, 6b, 8a, 8b, 8c and 9 to elaborate on structural information pertaining to various embodiments of the organic photovoltaic device 600b and the method 300.

For the purpose of this description, the method 300 is explained for manufacturing of the organic photovoltaic device 600b (Refer FIG. 6b). However, it will be readily apparent to those ordinarily skilled in the art that the method 300 can be used for manufacturing another organic photovoltaic device having the layers of the organic photovoltaic device 600b along with one or more additional layers.

The method 300 is initiated at step 302. At step 304, the first substrate 502 (Refer FIG. 5b) is provided. A surface area of the first substrate 502 is substantially equal to the pre-defined surface area, which is not greater than 900 square centimeters. For example, the first substrate 502 can be a square substrate of dimensions not greater than 30 cm X 30 cm.

The first substrate 502 includes a glass substrate coated with an electrically conducting layer or an electrically conducting grid. Examples of the electrically conducting layer include, but are not limited to, a transparent conducting oxide (TCO), like, Indium Tin Oxide (ITO), Fluorine doped Tin Oxide (FTO), and Aluminum doped Zinc Oxide or a Carbon Nanotube Layer. Examples of the electrically conducting grid may include, but are not limited to, grids made from Aluminum, Copper, Gold, Silver, Polysilicon and a Silicide.

In an embodiment, the first substrate 502 is cleaned prior to performing subsequent steps of the method 300. For example, the first substrate 502 may be cleaned by using an Ultrasonic or a Megasonic cleaning technique.

Thereafter, at step 306 a high-throughput depositing of a hole-transport layer 508 is performed on the first substrate 502. The high-throughput depositing of the hole-transport layer 508 is performed using a manufacturing process which is suitable for the pre-defined surface area, i.e., the small form factor of substrates. Examples of the manufacturing process include, but are not limited to, dip coating, spin coating, doctored blade processing, spray coating, screen printing, sputtering, electroforming and evaporation.

Generally, a high-throughput manufacturing process is a process that is suitable for mass production, and therefore, produces a large quantity of products in a given time similar to the high-throughput manufacturing process explained in conjunction with the method 100.

The hole-transport layer 508 is provided to enhance the transport of holes in the organic photovoltaic device 600b, thereby enhancing the efficiency of the organic photovoltaic device 600b.

Thereafter, at step 308, a first organic photoactive layer 510 is deposited on the hole-transport layer 508. The first organic photoactive layer 510 is responsible for generation of electricity in the organic photovoltaic device 600b. Photons present in the sun light received by the first organic photoactive layer 510 generate excitons, i.e., bound electron-hole pairs, within the first organic photoactive layer 510. These bound electron-hole pairs dissociate into free electrons and holes within the first organic photoactive layer 510. The free electrons and holes act as the charge carriers that are responsible for generating electricity. Examples of the materials used for the first organic photoactive layer 510, include, but are not limited to, polyphenylene vinylene, copper phthalocyanine, carbon fullerenes and fullerene derivatives such as Phenyl-C61-butyric acid methyl ester, i.e., PCBM.

The first organic photoactive layer 510 is deposited by using a batch deposition-process or an in-line process.

In the batch process for depositing the first organic photoactive layer 510, for example, an input set of multiple first substrates is provided. The first organic photoactive layer 510 is deposited on each first substrate 502 of the multiple first substrates. An output of the batch process is a set of multiple deposited first substrates, i.e., a set of the multiple first substrates deposited with the first organic photoactive layer 510. Thereafter, the multiple deposited first substrates are carried forward for further processing as per subsequent steps of the method 300.

In an in-line process, for example, the first substrate 502 is received as an input, deposited with the first organic photoactive layer 510, and a deposited first substrate is provided as an output. Thereafter, the deposited first substrate is carried forward for further processing as per the subsequent steps of the method 300, while another first substrate is received as an input.

Examples of processes that can be implemented as the batch-deposition process and the in-line process for the step 308 include, but are not limited to, dip coating, spin coating, doctored blade processing, spray coating, screen printing, sputtering, electroforming and evaporation.

It will be readily apparent to those ordinarily skilled in the art that either of the batch process and the in-line process may be included in the method 300 without deviating from the scope of the invention. It will also be readily apparent to those ordinarily skilled in the art that the method 300 may be optimized for high-throughput by using either the batch process or the in-line process.

Thereafter at step 310, an optional high-throughput depositing of a first electrically conducting layer 512 on said first organic photoactive layer 510 is performed. The first electrically conducting layer 512 is performed using a manufacturing process which is suitable for the pre-defined surface area, i.e., the small form factor of substrates. Examples of the manufacturing process include, but are not limited to, dip coating, spin coating, doctored blade processing, spray coating, screen printing, sputtering, electroforming and evaporation.

Thereafter, at step 312, a second organic photoactive layer 514 is optionally deposited on the first electrically conducting layer 512. The second organic photoactive layer 514 is also capable of converting solar energy in the form of light into electricity.

Further, the second organic photoactive layer 514 is also deposited by using a batch deposition-process or an in-line process.

As mentioned above and as depicted by the dashed box 313 in the method 300, the step 310 and the step 312 are optional. It will be readily apparent to those ordinarily skilled in the art that an organic photoactive device can be manufactured by omitting the step 310 and the step 312 from the method 300 without deviating from the scope of the present invention.

Performing the step 310 and the step 312 may have additional benefits as explained in conjunction with step 318.

For the purpose of this description, the subsequent steps of the method 300 are explained considering the presence of the step 310, the step 312 and the corresponding layers, i.e., the first electrically conducting layer 512 and the second organic photoactive layer 514.

Thereafter, at step 314, the second organic photoactive layer 514, the first electrically conducting layer 512, the first organic photoactive layer 510 and the hole-transport layer 508 are scribed from the first substrate 502 using a high-throughput method.

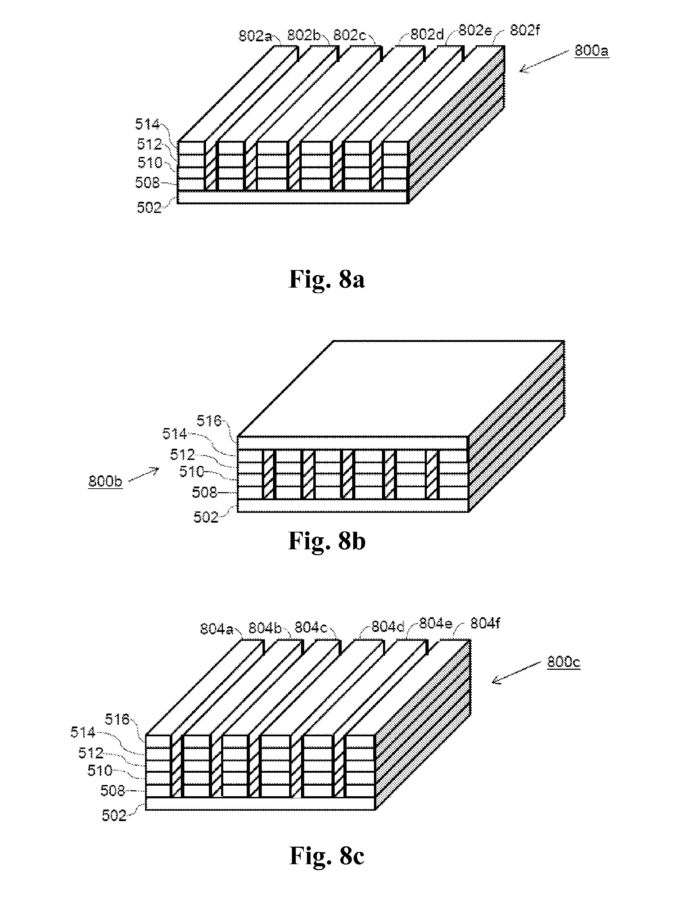

Referring to FIG. 8a, the high-throughput scribing of the second organic photoactive layer 514, the first electrically conducting layer 512, the first organic photoactive layer 510 and the hole-transport layer 508 forms strips 802a, 802b, 802c, 802d, 802e and 802f on the first substrate 502.

Thereafter, at step 316, a high-throughput depositing of a second electrically conducting layer 516 is performed on the scribed second organic photoactive layer 514 by using a manufacturing process which is suitable for the pre-defined surface area, i.e., the small form factor of substrates (Refer FIG. 8b). Examples of the manufacturing process include, but are not limited to, dip coating, spin coating, doctored blade processing, spray coating, screen printing, sputtering, electroforming and evaporation.

Thereafter, at step 318, the second electrically conducting layer 516 is scribed from the first substrate 502 using another high-throughput method, thereby forming an active substrate 800c (Refer FIG. 8c).

Referring to FIG. 8c, the high-throughput scribing of the second electrically conducting layer 516 forms strips 804a, 804b, 804c, 804d, 804e and 804f on the first substrate 502 and also connects the strips 804a, 804b, 804c, 804d, 804e and 804f in series, to form the active substrate 800c.

Each strip of the strips 804a, 804b, 804c, 804d, 804e and 804f has all the layers deposited on the first substrate 502, therefore, the each strip can act as two power-generating portions connected in series. A first power-generating portion formed between the electrically conducting layer or the electrically conducting grid deposited on the first substrate 502 and the first electrically conducting layer 512. A second power-generating portion formed between the first electrically conducting layer 512 and the second electrically conducting layer 516. The first power-generating portion and the second power-generating portion connected in series due to a common electrically conducting layer, i.e., the first electrically conducting layer 512. As a result, presence of the step 310 and the step 312 in the method 300 may help in increasing an efficiency and an electrical output of the organic photovoltaic device 600b by increasing a number of the power generating portions.

A strip voltage across the electrically conducting layer or the electrically conducting grid of the first substrate 502 and the second electrically conducting layer 516 is substantially similar for the each strip. For example, in a hypothetical scenario, the strip voltage can be 0.7 volts. When the strips 804a, 804b, 804c, 804d, 804e and 804f are connected in series at the step 318 to form the active substrate 800c, a combined voltage of the active substrate 800c is substantially equivalent to an addition of the strip voltages of all the strips 804a, 804b, 804c, 804d, 804e and 804f, i.e., 0.7 X6 = 4.2 volts.

At step 320, a second substrate 602 is provided having a surface area substantially equal to and not greater than the pre-defined surface area of less than 900 square centimeters, i.e., the small form factor. Examples of the material of the second substrate include, but are not limited to, glass.

In an embodiment, the second substrate 602 is cleaned prior to performing subsequent steps of the method 300. For example, the second substrate 602 may be cleaned using an Ultrasonic or a Megasonic cleaning technique.

At step 322, a high-throughput depositing of a gas-absorbent layer 604 is performed on the second substrate 602, thereby forming an inactive substrate 607. The high-throughput depositing of the gas-absorbent layer 604 is performed using a manufacturing process which is suitable for the pre-defined surface area, i.e., the small form factor of substrates. Examples of the manufacturing process include, but are not limited to, dip coating, spin coating, doctored blade processing, spray coating, screen printing, sputtering, electroforming and evaporation.

The gas-absorbent layer 604 is provided to absorb any gases that are released during the method 300 of manufacturing the organic photovoltaic device 600b and during a use of the organic photovoltaic device 600b. For example, the organic photovoltaic device 600b may undergo a curing process or exposure to heat and/or strong ultra-violet rays during the manufacturing in accordance with the method 300. This may result in release of contaminating gases from one or more layers in the organic photovoltaic device 600b. The gas-absorbent layer 604 prevents contamination of the organic photovoltaic device 600b from the contaminating gases.

At step 324, the active substrate 800c is encapsulated or bonded with the inactive substrate 607. The method of encapsulation is similar to the method 400 explained with reference to FIG. 4 in conjunction with the foregoing description of FIG. 1.

Thereafter, the method 300 of manufacturing the organic photovoltaic device 600b terminates at step 326.

As per the foregoing description of steps involved in the method 100, the method 100 does not involve a cutting process. Absence of the cutting process makes the method 100 efficient. Additionally, since the cutting process is not involved, a size of the organic photovoltaic device 600b is substantially similar to a size of the first substrate 502 and/or the second substrate 602, i.e., an input substrate is similar in size to an output device.

Each of the steps involved in the method 300 may be performed by either a batch process or an inline process. Further, the each of the steps involved in the method 300 may be implemented in such a way that a tact time of the manufacturing facility used to implement the method 300 is optimum. In an exemplary scenario, a time corresponding to each of the method steps in method 300 is designed to be substantially same, thereby reducing a waiting time between each process and optimizing the tact time for the manufacturing facility.

Referring to FIG. 9, one or more organic photovoltaic devices 600b manufactured as per the method 300 may be connected by using series or parallel connections 902a, 902b and 902c to obtain an arrangement 900 that can produce an electrical output as per a requirement, for example, the requirement of an external circuit 904. Additionally, one or more organic photovoltaic devices 600b may be connected by using series or parallel connections 902a, 902b and 902c to obtain an optimum electrical output.

It will be readily apparent to those ordinarily skilled in the art that the one or more organic photovoltaic devices 600b may also be connected with photovoltaic devices prepared from other methods in real life applications.

Various embodiments, as described above, provide a method for manufacturing an organic photovoltaic device, which has several advantages. One of the several advantages of some embodiments of this method is that a quality of the organic photovoltaic devices manufactured using this method is good, since, manufacturing processes used for deposition of various layers are conventional and standardized processes that have been tried and tested to be suitable for the pre-defined surface area of substrates to which the invention is applicable, i.e., the small form factor. This implies that a uniformity of deposited layers is substantially acceptable as well as the deposited layers have no or lesser defects like, pinholes and non-homogeneity of the layer. Further, since the substrates and organic photovoltaic device in accordance with the present invention are smaller in size, they can be easily handled and processed. This saves significant time and makes the process efficient. Further, no cutting is involved in the method disclosed in the present invention, which also helps make the method efficient.

A setup cost or capital cost of a manufacturing facility for implementing the method disclosed in the present invention is significantly lesser as compared to the existing methods. All the processes used in the present invention are conventional and standardized processes, therefore, the corresponding equipments are also standard and conventional and hence less expensive. Additionally, since the substrates and the organic photovoltaic device in accordance with the method of the present invention are of small form factor, the manufacturing equipment required is also correspondingly smaller in size, therefore, less expensive.

The method according to the present invention has another advantage that it enables mass production with high-throughput and yield since all the layers can be deposited by using high-throughput processes.

As described above, the capital cost for the manufacturing facility is less. Therefore, a cost of the organic photovoltaic device is also less. At the same time, an efficiency and quality of the organic photovoltaic device is better. Therefore, another advantage of implementing the method according to the present invention is significantly low cost per unit of power produced.

While the invention has been disclosed in connection with the preferred embodiments shown and described in detail, various modifications and improvements thereon will become readily apparent to those ordinarily skilled in the art. Accordingly, the spirit and scope of the present invention is not to be limited by the foregoing examples, but is to be understood in the broadest sense allowable by law. All documents referenced herein are hereby incorporated by reference.

## Claims

1. A method of manufacturing an organic photovoltaic device (600a, 600b), said organic photovoltaic device (600a, 600b) having a pre-defined surface area, said method comprising:
providing a first substrate (502), wherein a surface area of said first substrate (502) is substantially equal to said pre-defined surface area;
depositing an organic photoactive layer (504) on said first substrate (502), said organic photoactive layer (504) capable of absorbing solar radiation and generating electron-hole pairs;
depositing an electrically conducting layer (506) on said organic photoactive layer (504), said electrically conducting layer (506) capable of providing electrical contacts for connecting said organic photovoltaic device (600a, 600b) to an external circuit;
providing a second substrate (602), wherein a surface area of said second substrate (602) is substantially equal to said pre-defined surface area;
depositing a gas-absorbent layer (604) on said second substrate (602); and
encapsulating said first substrate (502) with said second substrate (602) to form said organic photovoltaic device (600a, 600b),
**characterized in that**:
said pre-defined surface area is equal to and not greater than 900 square centimetres;
said organic photoactive layer (504) is deposited by using either a batch deposition-process or an in-line process;
said electrically conducting layer (506) is deposited by using a first high-throughput deposition-processing, said first high-throughput deposition-processing being substantially suitable for said pre-defined surface area;
said gas-absorbent layer (604) is deposited by using a second high-throughput deposition-processing, said second high-throughput deposition-processing being substantially suitable for said pre-defined surface area; and
said method of manufacturing said organic photovoltaic device (600a, 600b) does not require a subsequent cutting process to achieve said pre-defined surface area of said organic photovoltaic device (600a, 600b).

2. The method as recited in claim 1, wherein said first substrate (502) comprises a glass substrate and at least one of a transparent conducting coating and a conducting grid.

3. The method as recited in claim 1 or 2, wherein said method is conventionally optimized for an optimum production rate with an optimum tact time.

4. The method as recited in one of claims 1 to 3, further comprising, depositing a hole-transport layer (508) on said first substrate (502) prior to depositing of said organic photoactive layer (504), wherein said hole-transport layer (508) being deposited using a high-throughput process, further wherein said high-throughput process for depositing said hole-transport layer (508) being suitable for said pre-defined surface area.

5. The method as recited in claim 4, wherein said high-throughput process for depositing said hole-transport layer (508) comprises dip coating, spin coating, doctored blade processing, spray coating, screen printing, sputtering, electroforming, evaporation, a batch deposition-processing and an in-line process.

6. The method as recited in one of claims 1 to 5, wherein said first high-throughput deposition-processing for depositing said electrically conducting layer (506) comprises dip coating, spin coating, doctored blade processing, spray coating, screen printing, sputtering, electroforming, evaporation, a batch deposition-processing and an in-line process.

7. The method as recited in one of claims 1 to 6, wherein said second high-throughput deposition-processing for depositing said gas-absorbent layer (604) comprises dip coating, spin coating, doctored blade processing, spray coating, screen printing, sputtering, electroforming, evaporation and an in-line process.

8. The method as recited one of claims 1 to 5, wherein said first high-throughput deposition-processing for depositing said electrically conducting layer (506) comprises either a batch deposition-processing or an in-line processing.

9. The method as recited in one of claims 1 to 5 or in claim 8, wherein said second high-throughput deposition-processing for depositing said gas-absorbent layer (604) comprises either a batch deposition-processing or an in-line processing.

10. The method as recited in one of claims 1 to 9, further comprising connecting one or more organic photovoltaic devices in at least one of parallel and series connections, whereby optimizing an electrical output from said one or more organic photovoltaic devices.

11. The method as recited in one of claims 1 to 9, further comprising:
scribing of said electrically conducting layer (506) and said organic photoactive layer (504) from said first substrate (502), wherein said scribing forms strips of said electrically conducting layer (506) and said organic photoactive layer (504) on said first substrate (502), thereby forming an active substrate (500a);
wherein said scribing of said electrically conducting layer (506) and said organic photoactive layer (504) from said first substrate (502) is done by using a high-throughput process.

12. A method of manufacturing an organic photovoltaic device (600a, 600b), said organic photovoltaic device (600a, 600b) having a pre-defined surface area, said method comprising:
providing a first substrate (502), wherein a surface area of said first substrate (502) is substantially equal to said pre-defined surface area;
depositing an organic photoactive layer (504) on said first substrate (502), said organic material layer capable of absorbing solar radiation and generating electron-hole pairs;
depositing an electrically conducting layer (506) on said organic photoactive layer (504), said electrically conducting layer (506) capable of providing electrical contacts for connecting said organic photovoltaic device (600a, 600b) to an external circuit;
scribing of said electrically conducting layer (506) and said organic photoactive layer (504) from said first substrate (502), wherein said scribing forms strips of said electrically conducting layer (506) and said organic photoactive layer (504) on said first substrate (502), whereby forming an active substrate (500a);
providing a second substrate (602), wherein a surface area of said second substrate (602) is substantially equal to said pre-defined surface area;
depositing a gas-absorbent layer (604) on said second substrate (602), whereby forming an inactive substrate (605); and
encapsulating said active substrate (500a) with said inactive substrate (605) to form said organic photovoltaic device (600a, 600b),
**characterized in that**:
said pre-defined surface area is equal to and not greater than 900 square centimetres;
said organic photoactive layer (504) is deposited by using either a batch deposition-process or an in-line process;
said electrically conducting layer (506) is deposited by using a first high-throughput deposition-processing, said first high-throughput deposition-processing being substantially suitable for said pre-defined surface area;
said scribing of said electrically conducting layer (506) and said organic photoactive layer (504) from said first substrate (502) is done using a high-throughput process;
said gas-absorbent layer (604) is deposited by using a second high-throughput deposition-processing, said second high-throughput deposition-processing being substantially suitable for said pre-defined surface area; and
said method of manufacturing said organic photovoltaic device (600a, 600b) does not require a subsequent cutting process to achieve said pre-defined surface area of said organic photovoltaic device (600a, 600b).
